# EUROPÄISCHE PATENTSCHRIFT

(11) **EP 1 402 632 B1**
(45) Veröffentlichungstag und Bekanntmachung des Hinweises auf die Patenterteilung: **09.08.2006**
(21) Anmeldenummer: 02750780.5
(22) Anmeldetag: 07.06.2002
(51) Int. Cl.: H03G 3/30

(54) **ARBEITSPUNKTOPTIMIERUNG VON SENDELEISTUNGSVERSTÄRKERN IN MOBILSTATIONEN**
OPTIMISATION OF THE OPERATING POINT OF TRANSMITTER POWER AMPLIFIERS IN MOBILE STATIONS
OPTIMISATION DU POINT DE FONCTIONNEMENT D'AMPLIFICATEURS DE PUISSANCE D'EMISSION DANS DES STATIONS MOBILES

(30) Priorität: 29.06.2001 DE 10131654; 29.06.2001 US 895595
(43) Veröffentlichungstag der Anmeldung: 31.03.2004
(73) Patentinhaber: Infineon Technologies AG, 81669 München (DE)
(72) Erfinder: WENZEL, Dietmar, 81549 München (DE); WEBER, Stephan, 81739 München (DE)
(74) Vertreter: Graf Lambsdorff, Matthias
(86) Internationale Anmeldenummer: PCT/DE2002/002089
(87) Internationale Veröffentlichungsnummer: WO 2003/005600

(56) Entgegenhaltungen:
- EP-A- 0 896 439
- US-A- 5 278 997
- US-A- 5 426 641

## Beschreibung

Die vorliegende Erfindung betrifft eine Vorrichtung zur Arbeitspunktoptimierung von Sendeleistungsverstärkern in Mobilstationen nach dem Oberbegriff des Patentanspruchs 1.

Innerhalb von Sendeeinrichtungen in Mobilstationen (MS) werden Sendeleistungsverstärker (PA, Power Amplifier) eingesetzt, welche das durch die Übertragungsdaten modulierte Sendesignal verstärken, bevor es der Antenne zugeführt wird. Die dafür notwendige Energie wird der in der MS enthaltenen Batterie entnommen. Die erforderliche effektive Sendeleistung richtet sich nach mehreren Parametern, z.B. Entfernung der MS zur Basisstation, der Funkkanaldämpfung, dem Rauschen des Funkkanals, den spektralen Eigenschaften des Funkkanals, dem Übertragungsverfahren, usw. Um Energie zu sparen und damit eine möglichst lange Batterienutzungsdauer zu erreichen, wird die Sendeleistung entsprechend einem oder mehreren dieser Parameter angepasst.

In Mobilfunksystemen, die auf dem Zeitmultiplexverfahren (TDM, Time Division Multiplex) beruhen, wird die Sendeleistung im allgemeinen für jeden Zeitschlitz gesondert festgelegt und ist für die Dauer des Zeitschlitzes konstant. Die Sendeleistung ist in der Regel in Stufen wählbar, wobei eine maximale Sendeleistung nicht überschritten werden darf. Zwischen den aktiven Zeitschlitzen wird der Sendeleistungsverstärker abgeschaltet.

Vor Beginn eines aktiven Zeitschlitzes wird der Sendeleistungsverstärker eingeschaltet und durch ein in der MS erzeugtes Steuersignal v(t) wird die Verstärkung vom Minimum auf den gewünschten Wert sanft hochgefahren, in der Weise, dass keine, die Nachbarkanäle störenden, Störspektren auftreten. Der Verlauf dieser Verstärkungs- bzw. Leistungsrampe wird durch ein Leistungsrampen-Steuergerät bestimmt. Während der aktiven Phase des Zeitschlitzes wird die Verstärkung näherungsweise konstant gehalten und am Ende wieder heruntergefahren.

Damit der Sendeleistungsverstärker die jeweils geforderte Verstärkung erbringen kann, muss sein Arbeitspunkt (AP) entsprechend gewählt werden. Da zu Beginn eines aktiven Zeitschlitzes aus dem genannten Steuersignal v(t) nicht ersichtlich ist, welche maximale Verstärkung vₘₐₓ im aktiven Teil des Zeitschlitzes benötigt wird, muss davon ausgegangen werden, dass es auch die größte einstellbare Verstärkung v₀ sein kann. Daher muss der AP von vornherein so gewählt werden, dass der Sendeleistungsverstärker die größtmögliche Verstärkung v₀ erbringen kann. In den meisten Fällen wird innerhalb eines aktiven Zeitschlitzes die maximal mögliche Verstärkung v₀ jedoch nicht benötigt.

Die grundsätzliche Stromaufnahme des Sendeleistungsverstärkers hängt jedoch von dem gewählten AP ab. Je höher dieser gewählt wird, desto größer ist die Stromaufnahme. Wird also bei kleinen Sendeleistungen der AP unnötig hoch gewählt, ist der Wirkungsgrad entsprechend gering und die Batterie wird unnötig belastet, was die Batterienutzungsdauer verkürzt.

Die Druckschrift US-A-5,278,997 beschreibt eine Schaltungsanordnung, wie sie etwa für eine Funkvorrichtung verwendet werden kann, und mit der ein vor eine Antenne geschalteter Ausgangsverstärker dynamisch vorgespannt werden kann. Dem Ausgangsverstärker wird am Beginn eines Sendevorgangs eine Vorspannung zugeführt, die aus einer Leistungsrampe und einer konstanten Spannung zusammengesetzt ist. So wie die Leistungsrampe einen vorgegebenen Endwert erreicht hat, bleibt die auf der entsprechenden Leitung zugeführte Spannung konstant, während gleichzeitig die auf der anderen Leitung zugeführte Spannung auf Null zurückgeführt wird. Durch eine derartige Überlagerung der Leistungsrampen am Beginn und am Ende von Sendevorgängen mit konstanten Spannungssignalen wird der Ausgangstransistor in einem Bereich betrieben, in dem das normalerweise während des Hochfahrens und des Herunterfahrens des Ausgangstransistors auftretende Frequenzübersprechen reduziert wird.

FR 2 768 574 und WO 00/48307 offenbaren Modulationsverstärker, die zur Amplitudenmodulation herangezogen werden.

Es ist daher Aufgabe der vorliegenden Erfindung, eine Vorrichtung zur Arbeitspunktoptimierung von Sendeleistungsverstärkern in Mobilfunkstationen anzugeben, durch die der Wirkungsgrad der Mobilfunkstationen verbessert werden kann und gleichzeitig stets die erforderliche Sendeleistung zur Verfügung steht.

Diese Aufgabe wird durch die kennzeichnenden Merkmale des Patentanspruchs 1 gelöst. Vorteilhafte Ausgestaltungen und Weiterbildungen sind in den Unteransprüchen angegeben.

Ein wesentlicher Aspekt der Erfindung liegt darin, daß eine zusätzliche Steuerspannung eingesetzt wird, deren Höhe ein Maß für die während des aktuellen Zeitschlitzes maximal benötigte Verstärkung vmax ist und die bereits vor Beginn des aktiven Zeitschlitzes dem Sendeleistungsverstärker zur Verfügung gestellt wird, um somit eine individuelle Arbeitspunkteinstellung mit dem Ziel einer Reduzierung des Leistungsverbrauches zu ermöglichen.

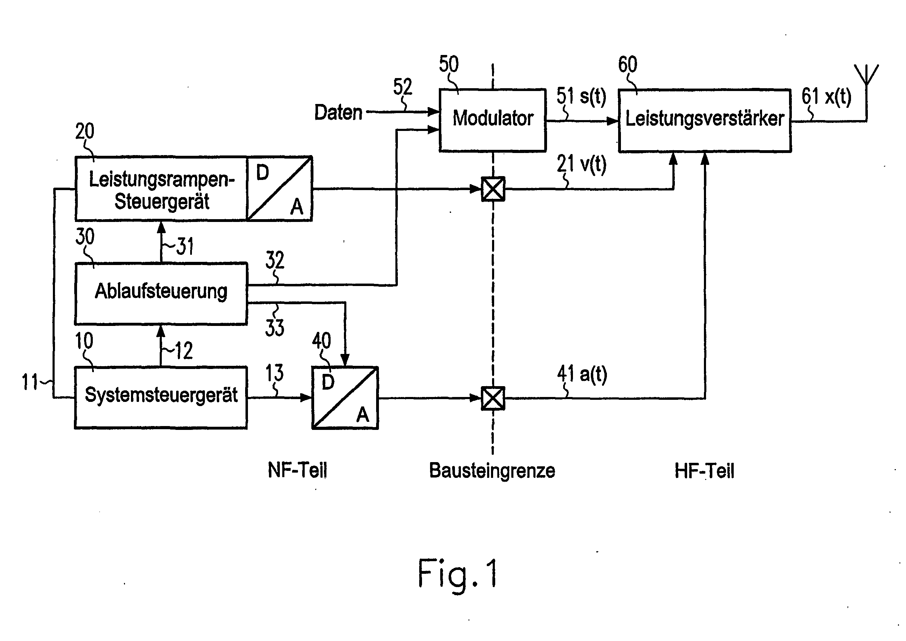

Eine allgemeine Ausführungsform einer erfindungsgemäßen Vorrichtung gemäß der Fig.1 weist einen D/A-Umsetzer 40 auf, der eingangsseitig von einem Systemsteuergerät 10 pro Zeitschlitz mindestens einen Digitalwert 13 erhält, den er ausgangsseitig als Analogwert 41 an den Leistungsverstärker 60 ausgibt, und zwar durch das Signal zeitlich synchronisiert mit der Ablaufsteuerung.

Dieser Ausführungsform können folgende Vorteile entnommen werden.
a) Die Systemsteuerung 10, welche auch die Form und Höhe der Leistungsrampen festlegt und durch die Verbindung 11 an das Leistungsrampen-Steuergerät 20 übermittelt, kennt somit auch die in einem Zeitschlitz benötigte maximale Verstärkung vmax und kann daher auch den Digitalwert 13 ermitteln, den sie an den D/A-Umsetzer 40 liefert.
b) Der Arbeitspunkt kann vor Beginn des Zeitschlitzes eingestellt werden.
c) Der genaue Zeitpunkt, wann ein neuer Analogwert 41 ausgegeben werden soll, lässt sich durch die Verknüpfung 33 mit der Ablaufsteuerung 30 exakt mit der Leistungsrampe und dem Zeitschlitz synchronisieren.
d) Die Anordnung lässt sich vollständig in den Baustein, mit dem gesteuert wird, integrieren.

Ferner sind folgende weitere Besonderheiten ersichtlich:
a) Da die Verstärkung weiterhin allein durch das Signal v(t) bestimmt wird, ist das System auch kompatibel mit Leistungsverstärkern, die über keine Möglichkeit verfügen, den Arbeitspunkt individuell einstellen zu können.
b) Der D/A-Umsetzer kann in den Zeitspannen zwischen aktiven Zeitschlitzen zur Stromersparnis abgeschaltet werden, wie dies im allgemeinen auch beim Leistungsrampen-Steuergerät und dem Leistungsverstärker der Fall ist.

Bei der Erfindung kann somit eine zeitschlitzspezifische Arbeitspunktoptimierung vorgenommen werden. Der Arbeitspunkt des Sendeleistungsverstärkers der Mobilfunkstation kann für jeden Zeitschlitz entsprechend der in diesem Zeitschlitz erforderlichen Sendeleistung bzw. der erforderlichen Verstärkung des Sendeleistungsverstärkers eingestellt werden. Somit braucht der Arbeitspunkt des Sendeleistungsverstärkers für jeden Zeitschlitz nicht höher als für die in diesem Zeitschlitz maximal erforderliche Verstärkung vₘₐₓ eingestellt zu werden.

Es ist erfindungsgemäß möglich, den Arbeitspunkt des Sendeleistungsverstärkers bereits vor dem Beginn der Leistungsrampe einzustellen. Ferner kann der zeitliche Verlauf und die Höhe der Verstärkung ausschließlich durch das Steuersignal v(t) festgelegt sein. Zur Realisierung der Erfindung wird maximal nur ein zusätzlicher Signalausgang benötigt.

Die erfindungsgemäße Arbeitspunktoptimierung ist insbesondere für Mobilstationen, welche die Standards GSM, EDGE oder TIA/EIA-136 (IS-136) unterstützen, geeignet.

Die Erfindung wird im folgenden anhand des bereits skizzierten Ausführungsbeispiels in Verbindung mit den Zeichnungen näher erläutert. Es zeigen:
Fig.1 ein Blockschaltbild eines Ausführungsbeispiels einer erfindungsgemäßen Vorrichtung zur Arbeitspunktoptimierung;
Fig.2 ein Zeitdiagramm für die Signale v(t) und a(t) für eine Sequenz unterschiedlicher Zeitschlitze;
Fig.3 ein beispielhaftes Diagramm für die Einstellung der Arbeitspunkte.

Fig. 1 zeigt eine Vorrichtung, die alle erforderlichen Elemente für die allgemeinste Form der Erfindung und zusätzliche weitere spezielle Ausgestaltungen enthält sowie zusätzliche Blöcke zeigt, die für das Systemverständnis vorteilhaft sind.

Die Vorrichtung in Fig. 1 enthält zunächst ein Systemsteuergerät 10, das Daten für die Leistungsrampen 11 an das Leistungsrampen-Steuergerät 20 und Synchronisationsinformation 12 an die Ablaufsteuerung 30 übermittelt. Das Leistungsrampen-Steuergerät 20 gibt seinerseits die Leistungsrampe mit Hilfe des D/A-Umsetzers als analoges Signal v(t) 21 zu den von der Ablaufsteuerung 30 durch die Synchronisationsinformation 31 festgelegten Zeitpunkten aus. Das Signal v(t) 21 wird dem Leitungsverstärker 60 zugeführt und bestimmt dessen Verstärkung und somit den Leistungspegel des Sendesignals x(t) 61.

Der Modulator 50 formt aus den Daten 52 durch die Synchronisationsinformation 32 zeitlich synchronisiert mit der Leistungsrampe das modulierte Signal s(t) 51, welches vom Leistungsverstärker 60 verstärkt und als Sendesignal x(t) 61 ausgegeben wird.

Als erfindungsgemäße Erweiterung enthält die in Fig. 1 gezeigte Vorrichtung einen D/A-Umsetzer 40, der eingangsseitig digitale Werte 13 von der Systemsteuerung 10 erhält, die er ausgangsseitig als analoges Signal bzw. Spannung a(t) 41 ausgibt, nachdem er über die Synchronisationsleitung 33, z.B. durch einen Impuls, von der Ablaufsteuerung 30 dazu aufgefordert wurde. Das Signal a(t) korrespondiert dabei mit der im zugehörigen Zeitschlitz maximal benötigten Verstärkung vmax und bleibt solange unverändert, bis eingangsseitig ein neuer Digitalwert anliegt und ein Impuls von der Ablaufsteuerung gesendet wurde. Ist der D/A-Umsetzer abgeschaltet, wird der Wert a(t) = 0 V ausgegeben.

Das Signal a(t) 41 wird dem Leistungsverstärker 60 zugeführt und wird dort als Parameter für die Arbeitspunkteinstellung und/oder anderer Verstärkerparameter verwendet.

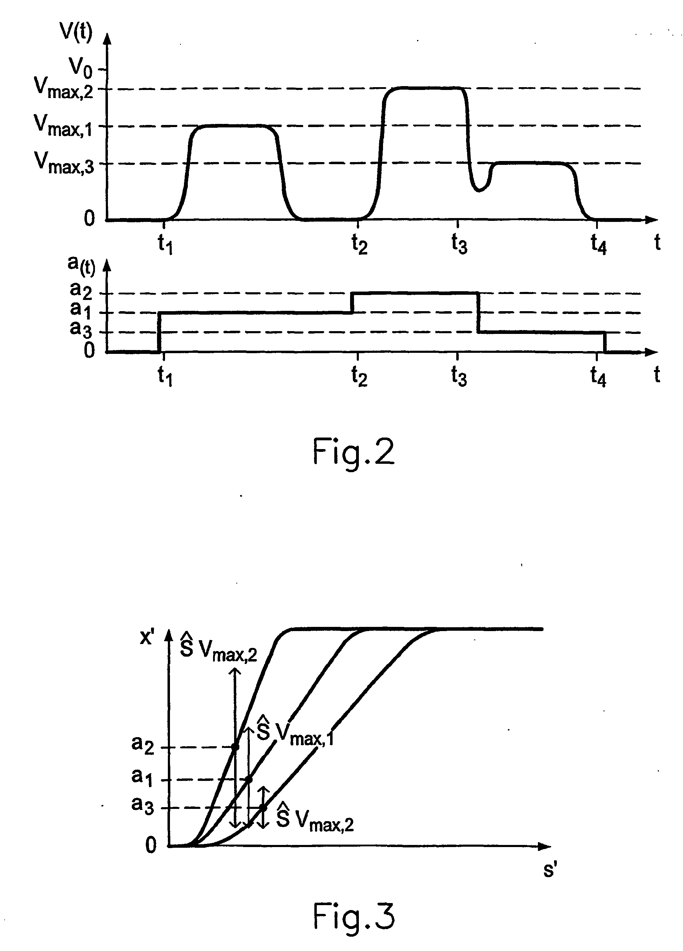

Fig. 2 zeigt beispielhaft den vereinfachten zeitlichen Verlauf der Signale v(t) und a(t) für eine Sequenz unterschiedlicher Zeitschlitze. Das Signal a(t) wird vor Beginn der Leistungsrampe ausgegeben, um den Leistungsverstärker in den entsprechenden Arbeitspunkt zu bringen. Bei aufeinanderfolgenden aktiven Zeitschlitzen, wird der Arbeitspunkt während der Übergangsphase umgeschaltet.

Die Zeitpunkte t₁-t₄ kennzeichnen folgende Phasen:
t₁ Beginn der Leistungsrampe, die Verstärkung auf v_{max,1} hoch- und herunterfährt
t₂ Beginn der Leistungsrampe, die Verstärkung auf v_{max,2} hochfährt
t₃ Beginn der Leistungsrampe, die Verstärkung von v_{max,2} auf v_{max,3} herunterfährt
t₄ Ende der Sendesequenz.

Fig. 3 zeigt beispielhaft die Einstellung der Arbeitspunkte des Leistungsverstärkers 60 sowie die Aussteuerbereiche des Sendesignals für die in Fig. 2 dargestellten Betriebszustände. <s> ist dabei die maximale Amplitude des modulierten Signals s(t) 51.

## Patentansprüche

1. Vorrichtung zur Arbeitspunktoptimierung von Sendeleistungsverstärkern (60) in Mobilstationen mit Zeitmultiplexbetrieb, mit
- einem Leistungsrampen-Steuergerät (20) für die Erzeugung und Übermittlung einer Leistungsrampe v(t) für einen Zeitschlitz an den Sendeleistungsverstärker (60),
**gekennzeichnet durch**,
- ein Systemsteuergerät (10) für die Erzeugung und Übermittlung eines Steuersignals an den Sendeleistungsverstärker (60), welches Steuersignal **durch** einen Parameter a gebildet wird, dessen Höhe ein Maß für die in dem Zeitschlitz benötigte maximale Verstärkung ist, wobei
- der Arbeitspunkt des Sendeleistungsverstärkers (60) auf der Basis des Parameters a vor Beginn des Zeitschlitzes eingestellt wird.

2. Vorrichtung nach Anspruch 1,
**dadurch gekennzeichnet, dass**
- das Steuersignal ein analoges Signal, insbesondere eine Steuerspannung ist.

3. Vorrichtung nach Anspruch 1,
**dadurch gekennzeichnet, dass**
- das Steuersignal ein digitales Signal ist, das eine stufenweise Umschaltung des Arbeitspunktes erlaubt.

4. Vorrichtung nach Anspruch 1,
**dadurch gekennzeichnet, dass**
- das Steuersignal zur Arbeitspunkteinstellung in dem Baustein erzeugbar ist, der das Leistungsrampen-Steuergerät (20) und/oder den zugehörigen D/A-Umsetzer enthält.

5. Vorrichtung nach Anspruch 3,
**dadurch gekennzeichnet, dass**
- ein für die Arbeitspunkteinstellung erforderlicher D/A-Umsetzer im Leistungsverstärker (60) integriert ist.

6. Vorrichtung nach Anspruch 1,
**dadurch gekennzeichnet, dass**
- das Steuersignal gleichzeitig zum Ein- und Ausschalten des Sendeleistungsverstärkers (60) verwendbar ist.

7. Vorrichtung nach Anspruch 1,
**dadurch gekennzeichnet, dass**
- die Leistungsverstärkung unabhängig vom Steuersignal zur Arbeitspunkteinstellung gewählt und/oder einstellbar ist.

8. Vorrichtung nach Anspruch 1,
**dadurch gekennzeichnet, dass**
- das Steuersignal zur Arbeitspunkteinstellung einen definierten, insbesondere einstellbaren zeitlichen Bezug zum Leistungsrampen-Steuersignal hat.

9. Vorrichtung nach Anspruch 1,
**dadurch gekennzeichnet, dass**
- das Systemsteuergerät (10) mit einem D/A-Umsetzer (40) gekoppelt ist, und
- der D/A-Umsetzer (40) für das Steuersignal während inaktiven Zeitschlitzen abschaltbar ist.

## Claims

1. Device for optimizing the operating point of transmitter power amplifiers (60) in mobile stations with time division multiplex operation, comprising
- a power ramp control device (20) for generating and transmitting a power ramp v(t) for a time slot to the transmitter power amplifier (60),
**characterized by**
- a system control device (10) for generating and transmitting a control signal to the transmitter power amplifier (60), which control signal is formed by a parameter a, the magnitude of which is a measure of the maximum gain required in the time slot,
- the operating point of the transmitter power amplifier (60) being set on the basis of the parameter a before the beginning of the time slot.

2. Device according to Claim 1, **characterized in that**
- the control signal is an analogue signal, particularly a control voltage.

3. Device according to Claim 1, **characterized in that**
- the control signal is a digital signal which allows the operating point to be switched over step by step.

4. Device according to Claim 1, **characterized in that**
- the control signal for setting the operating point can be generated in the chip which contains the power ramp control device (20) and/or the associated D/A converter.

5. Device according to Claim 3, **characterized in that**
- a D/A converter required for setting the operating point is integrated in the power amplifier (60).

6. Device according to Claim 1, **characterized in that**
- the control signal can be used at the same time for switching the transmitter power amplifier (60) on and off.

7. Device according to Claim 1, **characterized in that**
- the power gain can be selected and/or set independently of the control signal for setting the operating point.

8. Device according to Claim 1, **characterized in that**
- the control signal for setting the operating point has a defined, particularly an adjustable, temporal relationship to the power ramp control signal.

9. Device according to Claim 1, **characterized in that**
- the system control device (10) is coupled to a D/A converter (40), and
- the D/A converter (40) for the control signal can be switched off during inactive time slots.

## Revendications

1. Dispositif pour l'optimisation du point de fonctionnement d'amplificateurs de puissance d'émission (60) dans des stations mobiles avec exploitation en multiplexage temporel, comprenant :
- un appareil de commande de rampes de puissance (20) pour la production et la transmission d'une rampe de puissance v (t) pour un créneau temporel à l'amplificateur de puissance d'émission (60),
**caractérisé par**
- un appareil de commande de système (10) pour la production et la transmission d'un signal de commande à l'amplificateur de puissance d'émission (60), lequel signal de commande est formé par un paramètre a dont la hauteur est une mesure de l'amplification maximale nécessaire dans le créneau temporel,
- le point de fonctionnement de l'amplificateur de puissance d'émission (60) étant réglé sur la base du paramètre a avant le début du créneau temporel.

2. Dispositif selon la revendication 1,
**caractérisé par le fait que**
- le signal de commande est un signal analogique, notamment une tension de commande.

3. Dispositif selon la revendication 1,
**caractérisé par le fait que**
- le signal de commande est un signal numérique qui permet une commutation échelonnée du point de fonctionnement.

4. Dispositif selon la revendication 1,
**caractérisé par le fait que**
- le signal de commande destiné au réglage du point de fonctionnement peut être produit dans le composant qui contient l'appareil de commande de rampes de puissance (20) et/ou le convertisseur numérique / analogique D/A associé.

5. Dispositif selon la revendication 3,
**caractérisé par le fait que**
- un convertisseur numérique / analogique D/A nécessaire au réglage du point de fonctionnement est intégré dans l'amplificateur de puissance (60).

6. Dispositif selon la revendication 1,
**caractérisé par le fait que**
- le signal de commande est utilisable en même temps pour la mis en service et l'arrêt de l'amplificateur de puissance d'émission (60).

7. Dispositif selon la revendication 1,
**caractérisé par le fait que**
- l'amplification de puissance est choisie et/ou réglable indépendamment du signal de commande destiné au réglage du point de fonctionnement.

8. Dispositif selon la revendication 1,
**caractérisé par le fait que**
- le signal de commande destiné au réglage du point de fonctionnement a un rapport temporel défini, notamment réglable, au signal de commande de rampes de puissance.

9. Dispositif selon la revendication 1,
**caractérisé par le fait que**
- l'appareil de commande de système (10) est couplé à un convertisseur numérique / analogique D/A (40), et
- le convertisseur numérique / analogique D/A (40) pour le signal de commande peut être arrêté pendant des créneaux temporels inactifs.
